# FASCICULE DE BREVET EUROPEEN

(11) **EP 0 716 486 B1**
(45) Date de publication et mention de la délivrance du brevet: **26.08.1998**
(21) Numéro de dépôt: 95402728.0
(22) Date de dépôt: 04.12.1995
(51) Int. Cl.: G02F 2/02, H01S 3/25, H04B 10/17

(54) **Dispositif convertisseur de longueur d'onde**
Wellenlängenkonverter
Wavelength convertor

(30) Priorité: 06.12.1994 FR 9414639
(43) Date de publication de la demande: 12.06.1996
(73) Titulaire: FRANCE TELECOM, 75015 Paris (FR)
(72) Inventeur: Simon, Jean-Claude, F-22700 Louannec (FR); Valiente, Ivan, F-22300 Caouennec (FR); Lablonde, Laurent, F-22300 Lannion (FR)
(74) Mandataire: Martin, Jean-Jacques

(56) Documents cités:
- US-A- 5 264 960
- IEEE PHOTONICS TECHNOLOGY LETTERS, vol. 4, no. 10, pages 1168-1171, XP 000316548 WIESENFELD J M ET AL 'CASCADABILITY AND FANOUT OF SEMICONDUCTOR OPTICAL AMPLIFIER WAVELENGTH SHIFTER'
- IEEE PHOTONICS TECHNOLOGY LETTERS, vol. 5, no. 6, 1 Juin 1993 pages 657-660, XP 000384055 JOERGENSEN C ET AL '4 GB/S OPTICAL WAVELENGTH CONVERSION USING SEMICONDUCTOR OPTICAL AMPLIFIERS'

## Description

La présente invention concerne le domaine des dispositifs optiques et plus particulièrement celui des convertisseurs de longueur d'onde utilisant des amplificateurs optiques à semi-conducteur.

Les convertisseurs de longueur d'onde ont vocation à être utilisés dans les réseaux de télécommunications dits "multicolores", pour transmettre une information portée par une première onde lumineuse à une deuxième onde lumineuse, dont la valeur de la longueur d'onde est choisie en fonction d'un récepteur déterminé à atteindre, au sein d'un réseau de télécommunications dans lequel le routage des signaux optiques dépend de la valeur de leur longueur d'onde.

On a proposé dans le brevet US-5 264 960 un convertisseur de longueur d'onde exploitant le phénomène dit de "saturation croisée du gain", dans un amplificateur optique à semi-conducteur. Ce dernier reçoit une première onde lumineuse, dite "onde de pompe", de longueur d'onde λₚ, modulée en intensité de manière à porter une information, par exemple sous forme de signal binaire, et une deuxième onde lumineuse, dite "onde de sonde", de longueur d'onde λₛ, à laquelle l'information portée par l'onde de pompe doit être transmise. Le niveau haut de l'intensité de l'onde de pompe, traduisant l'état binaire "1", diminue, par phénomène de saturation, le nombre de porteurs électroniques disponibles dans l'amplificateur optique à semi-conducteur pour l'amplification de l'onde de sonde, donc le gain de l'amplificateur optique pour cette dernière. Puisque l'amplification de l'onde de sonde évolue dans un rapport inverse de la variation de l'intensité de l'onde de pompe, en envoyant dans l'amplificateur optique une onde de sonde d'intensité constante, on obtient en sortie de l'amplificateur optique une onde de sonde porteuse de la même information que l'onde de pompe. Toutefois, le niveau bas de l'intensité de l'onde de sonde quittant l'amplificateur optique, traduisant l'état binaire "0", n'est pas nul, et tend à augmenter lorsque le débit de données binaires croît, ce qui entraîne une diminution du contraste, c'est-à-dire du rapport des niveaux bas et haut d'intensité traduisant respectivement les états binaires "0" et "1" de l'onde de sonde, encore appelé "taux d'extinction". On a cherché à améliorer le contraste pour des débits d'informations élevés (typiquement supérieurs à 2,5 Gbits/s.), et l'on a proposé des convertisseurs de longueur d'onde n'exploitant plus le phénomène de saturation croisée du gain, mais le déphasage de l'onde de sonde induit par la variation de l'intensité de l'onde de pompe dans l'amplificateur optique. Des convertisseurs exploitant le déphasage de l'onde de sonde ont ainsi été décrits dans les publications "IEEE Photonics Technology Letters", Vol. 6 N° 1, Jan. 1994 pages 53-55, et "Twenteeth European Conference on Optical Communication, Post-deadline paper", page 67, qui utilisent le principe des interféromètres de Mach-Zehnder ou de Michelson. Si le taux d'extinction est amélioré par rapport aux convertisseurs connus exploitant le phénomène de saturation croisée du gain, en revanche la bande passante optique est moins large et les convertisseurs décrits dans les publications précitées nécessitent un contrôle précis de la différence de marche entre les rayons interférant (de l'ordre du dixième de la longueur d'onde). Ces convertisseurs sont donc délicats à mettre en oeuvre.

La présente invention a pour objet un dispositif convertisseur de longueur d'onde perfectionné, comportant au moins deux amplificateurs optiques à semi-conducteur, ce dispositif étant destiné à la transmission d'une information portée par un faisceau incident d'onde de pompe, de longueur d'onde λₚ, à une onde de sonde de longueur d'onde λₛ. De façon caractéristique, le dispositif comporte des moyens pour fractionner le faisceau incident d'onde de pompe en faisceaux secondaires d'onde de pompe et injecter sur chacun desdits amplificateurs optiques un faisceau secondaire d'onde de pompe respectif, et lesdits amplificateurs optiques sont agencés en série sur le trajet de l'onde de sonde, de manière à moduler chacun en intensité cette dernière par phénomène de saturation croisée du gain avec le faisceau secondaire d'onde de pompe associé, en vue d'obtenir en sortie du dispositif une onde de sonde porteuse de ladite information. On obtient grâce à l'invention, en sortie du dispositif convertisseur, une onde de sonde qui présente un taux d'extinction amélioré par rapport au taux d'extinction que l'on obtiendrait avec chacun desdits amplificateurs optiques utilisé isolément. Plus particulièrement, si le taux d'extinction de l'onde de sonde à la sortie d'un amplificateur optique utilisé isolément est η, le taux d'extinction à la sortie d'un dispositif convertisseur comprenant N amplificateurs optiques identiques disposés en série conformément à l'invention est en première approximation égal à η^{N}.

Dans une réalisation de l'invention, au moins un faisceau secondaire d'onde de pompe est injecté sur l'amplificateur optique associé avec un sens de propagation inverse de celui de l'onde de sonde. Avantageusement, le dispositif comporte un isolateur optique placé sur le trajet du faisceau secondaire d'onde de pompe à sa sortie de l'amplificateur optique qui le reçoit avec un sens de propagation contraire à celui de l'onde de sonde, cet isolateur optique étant agencé pour arrêter ledit faisceau secondaire d'onde de pompe tout en permettant la traversée de l'onde de sonde.

Dans une réalisation de l'invention, tous les amplificateurs optiques reçoivent le faisceau secondaire d'onde de pompe associé avec un sens de propagation contraire à celui de l'onde de sonde.

Avantageusement, le dispositif est intégré dans une structure monolithique ou hybride. On entend par structure monolithique une structure dans laquelle les composants sont réalisés sur un même substrat et par structure hybride une structure dans laquelle les composants sont rapportés sur un même support.

Avantageusement, le dispositif comporte un atténuateur placé sur le trajet de l'onde de sonde entre deux amplificateurs optiques successivement traversés par ladite onde de sonde, de manière à ce que l'intensité de l'onde de sonde incidente sur chacun des amplificateurs optiques ait même amplitude de crête.

Avantageusement, le dispositif comporte au moins une ligne à retard disposée sur le trajet d'un faisceau secondaire d'onde de pompe, cette ligne à retard étant agencée de sorte que l'information portée par lesdits faisceaux secondaires d'onde de pompe arrive sur les amplificateurs optiques respectifs en synchronisme avec l'information portée par l'onde de sonde.

Dans une réalisation de l'invention, le dispositif comporte au moins un filtre placé sur le trajet de l'onde de sonde à sa sortie d'un amplificateur optique, ce filtre étant de sélectivité choisie de manière à arrêter l'onde de pompe et à laisser passer l'onde de sonde.

Dans une réalisation de l'invention, le dispositif comporte une source optique adaptée à émettre une onde de sonde d'intensité constante, à laquelle ladite information doit être transmise.

Avantageusement, ladite information est un signal binaire de débit supérieur ou égal à 10 Gbits/s.

D'autres caractéristiques et avantages de la présente invention apparaîtront à la lecture de la description détaillée qui va suivre, non limitative, de trois exemples de réalisation de l'invention, et à l'examen du dessin annexé sur lequel:
- la figure 1 est une représentation schématique d'un dispositif conforme à un premier exemple de réalisation de l'invention,
- la figure 2 est une représentation schématique d'un dispositif conforme à un deuxième exemple de réalisation de l'invention,
- la figure 3 est une représentation schématique d'un dispositif conforme à troisième exemple de réalisation de l'invention,
- les figures 4 et 5 représentent des résultats obtenus par simulation,
- les figures 6 et 7 correspondent à des résultats expérimentaux obtenus à l'aide d'un dispositif conforme à l'invention.

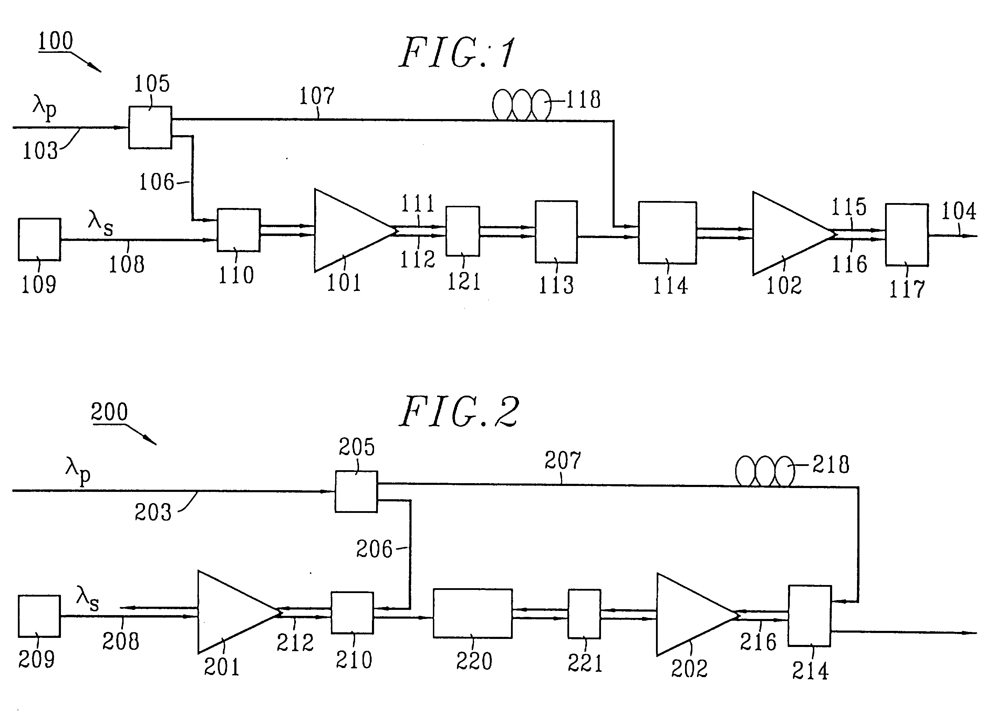

Les dispositifs conformes à l'invention représentés sur les figures 1 à 3 comportent chacun deux amplificateurs optiques à semi-conducteur. Il est bien entendu que l'invention se généralise sans difficultés à un dispositif comprenant un nombre quelconque N (supérieur ou égal à deux) d'amplificateurs optiques à semi-conducteur.

Le dispositif convertisseur 100 représenté sur la figure 1 utilise deux amplificateurs optiques à semi-conducteur 101 et 102, identiques, connus en eux-mêmes. Le dispositif 100 reçoit en entrée une onde de pompe 103, de longueur d'onde λₚ, modulée en intensité de manière à porter une information utile, par exemple un signal binaire à haut débit, typiquement supérieur à 10 Gbits/s. L'onde de pompe 103, acheminée jusqu'au dispositif 100 de façon connue en soi par fibre optique, provient par exemple d'un émetteur d'un premier réseau local de télécommunications. Le dispositif 100 délivre en sortie une onde de sonde 104 de longueur d'onde λₛ différente de λₚ, porteuse de ladite information utile. Cette onde de sonde 104 est dirigée par exemple vers un récepteur d'un deuxième réseau local de télécommunications, à interconnecter avec le premier, le routage de l'onde de sonde 104 étant déterminé par la valeur de la longueur d'onde λₛ. L'onde de sonde 104 est acheminée à partir du dispositif 100 vers le deuxième réseau local de télécommunications par fibre optique, de façon connue en soi.

Le faisceau incident d'onde de pompe 103 est divisé en deux faisceaux secondaires 106 et 107 d'amplitudes égales, respectivement injectés dans les amplificateurs optiques à semi-conducteur 101 et 102, comme cela va être précisé dans la suite. Plus particulièrement, la fibre optique dans laquelle se propage l'onde de pompe 103 est reliée en entrée à l'une des deux voies d'un coupleur directionnel 105, les faisceaux secondaires 106 et 107 étant respectivement récupérés en sortie sur les deux voies du coupleur 105. Les faisceaux secondaires 106 et 107 sont acheminés par tout moyen connu de l'homme du métier, fibre optique ou guide optique, vers les amplificateurs optiques 101 et 102. Plus généralement, les composants optiques constituant le dispositif 100 sont reliés soit par fibres optiques dans le cas où celui-ci est formé par un assemblage de composants optiques discrets, soit par guides optiques lorsque ces composants sont intégrés dans une structure monolithique ou hybride. Une ligne à retard 118, connue en elle-même, est placée sur le trajet de l'un des faisceaux secondaires 106 et 107, comme cela sera précisé dans la suite.

Une onde de sonde 108, d'intensité constante et de longueur d'onde λₛ, est délivrée par une source optique 109 connue en elle-même, et traverse successivement les amplificateurs optiques à semi-conducteur 101 et 102, ces derniers étant disposés en série sur le trajet de l'onde de sonde 108.

L'injection, dans l'amplificateur optique 101, de l'onde de sonde 108 et du faisceau secondaire 106 d'onde de pompe associé, s'effectue au moyen d'un coupleur directionnel 110, recevant en entrée sur ses deux voies respectivement l'onde de sonde 108 et le faisceau secondaire 106 d'onde de pompe, l'une des voies étant reliée en sortie à l'amplificateur optique 101. Ce dernier délivre un faisceau émergeant constitué par une onde de pompe amplifiée 111 et une onde de sonde modulée 112. L'amplificateur optique 101 est conçu, de façon connue de l'homme du métier, de sorte que l'onde de sonde incidente soit amplifiée avec un gain dépendant de l'intensité de l'onde de pompe incidente, par phénomène de saturation croisée du gain.

Un filtre 113, calé sur λₛ, connu en lui-même, est placé sur le trajet du faisceau émergeant de l'amplificateur optique 101 pour arrêter l'onde de pompe amplifiée 111 et ne laisser passer que l'onde de sonde modulée 112, en direction de l'amplificateur optique 102.

Conformément à l'invention, l'amplificateur optique 102 est disposé sur le trajet de l'onde de sonde modulée 112. Cet amplificateur optique 102 est attaqué par le faisceau secondaire 107 d'onde de pompe provenant du même faisceau incident d'onde de pompe 103 que le faisceau secondaire 106 d'onde de pompe reçu par l'amplificateur 101 ; plus précisément, un coupleur directionnel 114 reçoit en entrée sur une voie l'onde de sonde modulée 112 et sur l'autre voie le faisceau secondaire 107 d'onde de pompe. L'une des voies est reliée en sortie à l'amplificateur optique 102 et ce dernier délivre une onde de pompe amplifiée 115 et une onde de sonde modulée 116.

Un filtre 117, calé sur λₛ, est placé sur le trajet du faisceau émergeant de l'amplificateur optique 102 pour arrêter l'onde de pompe amplifiée 115 et ne laisser que l'onde de sonde modulée 116 quitter le dispositif 100. On a référencé 104 l'onde de sonde à la sortie du filtre 117. Si η désigne le taux d'extinction de l'onde de sonde à la sortie de l'amplificateur optique 101, le taux d'extinction de l'onde de sonde 104 à la sortie du dispositif 100 est en première approximation égal à η². Avec N étages, le taux d'extinction serait égal, en première approximation, à η^{N}.

La traversée par l'onde de sonde 108 de l'amplificateur optique 101 s'accompagne d'une amplification de celle-ci ; un atténuateur 121 connu en lui-même est placé sur le trajet de l'onde de sonde modulée 112 émergeant de l'amplificateur optique 101, de manière à ce que l'intensité de crête de l'onde de sonde modulée 112, incidente sur l'amplificateur optique 102, soit la même que celle de l'onde de sonde 108 incidente sur l'amplificateur optique 101. La ligne à retard 118, placée sur le trajet du faisceau secondaire 107 d'onde de pompe, est choisie de manière à ce que l'information portée par le faisceau secondaire 107 d'onde de pompe arrive en synchronisme avec l'information portée par l'onde de sonde modulée 112 incidente sur l'amplificateur 102, compte tenu du retard lié à la traversée de l'amplificateur optique 101 et des différents composants optiques par l'onde de sonde 108.

Dans le dispositif 100, l'onde de pompe et l'onde de sonde se propagent dans chacun des amplificateurs optiques 101 et 102 avec le même sens, configuration dite "co-propagative".

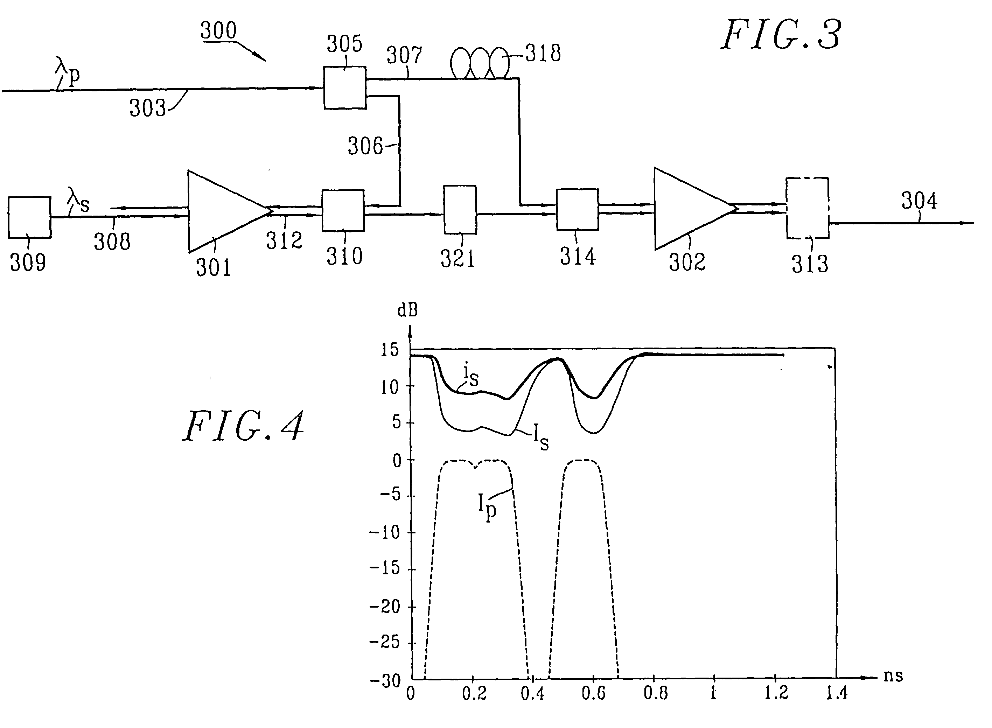

En variante, et comme illustré par la figure 2, on peut réaliser un dispositif convertisseur 200 dans lequel l'onde de pompe et l'onde de sonde se propagent en sens contraires dans chacun des amplificateurs optiques, configuration dite "contra-propagative".

Le dispositif 200 reçoit une onde de pompe 203 et la divise en deux faisceaux secondaires 206 et 207 au moyen d'un coupleur directionnel 205, de la même façon que cela est réalisé dans le dispositif 100 décrit précédemment.

Une onde de sonde 208 d'intensité constante, délivrée par une source optique 209, est injectée directement dans un amplificateur optique 201. Ce dernier délivre en sortie une onde de sonde modulée 212. L'amplificateur optique 201 est relié à une voie d'un coupleur directionnel 210, agencé pour récupérer l'onde de sonde modulée 212 quittant l'amplificateur 201 et agencé pour injecter, avec un sens de propagation contraire de celui de l'onde de sonde 208, le faisceau secondaire 206 d'onde de pompe. Le coupleur 210 a une voie recevant en entrée le faisceau secondaire 206, tandis que l'autre voie du coupleur 210 reçoit en entrée l'onde de sonde modulée 212 quittant l'amplificateur optique 201 et dirige en sortie l'onde de sonde modulée 212 vers l'amplificateur optique 202. Ce dernier est disposé, conformément à l'invention, sur le trajet de l'onde de sonde modulée 212 émergeant de l'amplificateur optique 201. L'amplificateur optique 202 reçoit le faisceau secondaire 207 d'onde de pompe en sens contraire du sens de propagation de l'onde de sonde modulée 212. L'injection du faisceau secondaire 207 d'onde de pompe dans l'amplificateur optique 202 s'effectue au moyen d'un coupleur directionnel 214. Ce dernier reçoit sur une voie en entrée le faisceau secondaire 207 d'onde de pompe ; l'autre voie reçoit en entrée l'onde de sonde modulée 216 quittant l'amplificateur 202. Une ligne à retard 218, connue en elle-même, est placée sur le trajet du faisceau secondaire 207 pour tenir compte du retard lié à la traversée de l'amplificateur optique 201 et des différents composants optiques par l'onde de sonde 208, de manière à ce que l'information portée par le faisceau secondaire 207 d'onde de pompe arrive en synchronisme avec l'information portée par l'onde de sonde modulée 212 incidente sur l'amplificateur optique 202. L'onde de sonde modulée quittant le dispositif 200 est référencée 204.

Un atténuateur 221, connu en lui-même, est placé sur le trajet de l'onde de sonde modulée 212, de manière à ce que l'amplitude de crête de l'onde de sonde incidente sur chacun des amplificateurs optiques 201 et 202 soit la même.

Le dispositif 200 présente l'avantage, par rapport au dispositif 100 précédemment décrit, de rendre possible l'emploi, pour arrêter le faisceau d'onde de pompe émergeant de l'amplificateur 202 en direction de l'amplificateur 201, d'un isolateur optique 220 à la place d'un filtre. L'isolateur 220, connu en lui-même, est passant dans le sens de la propagation de l'onde de sonde 212 émergeant de l'amplificateur optique 201 et non-passant dans le sens de propagation inverse, correspondant à celui du faisceau d'onde de pompe émergeant de l'amplificateur optique 202. L'emploi d'un isolateur optique, composant passif, présente notamment l'avantage, par rapport à l'emploi d'un filtre, composant actif, de ne pas nécessiter l'emploi d'un système de commande d'accord pour le caler sur la longueur d'onde voulue.

Le dispositif convertisseur 300 représenté sur la figure 3 comporte deux amplificateurs optiques identiques 301 et 302, et réunit des configurations co-propagative et contra-propagative. Le dispositif 300 reçoit en entrée une onde de pompe 303 qui est divisée en deux faisceaux secondaires 306 et 307 au moyen d'un coupleur directionnel 305, de la même façon que pour les réalisations précédentes.

Une source optique 309 délivre une onde de sonde 308 d'intensité constante, envoyée directement dans l'amplificateur optique 301. Le faisceau secondaire 306 d'onde de pompe est injecté dans l'amplificateur optique 301 en sens contraire de celui de la propagation de l'onde de sonde 308, grâce à un coupleur directionnel 310, agencé de la même manière que le coupleur 210 de la réalisation précédente. L'amplificateur optique 302 est disposé sur le trajet de l'onde de sonde modulée 312 émergeant de l'amplificateur optique 301. Un coupleur directionnel 314 est utilisé pour injecter, avec les mêmes sens de propagation, l'onde de sonde modulée 312 et le faisceau secondaire 307 d'onde de pompe dans l'amplificateur optique 302. Plus précisément, le coupleur 314 reçoit sur une voie en entrée l'onde de sonde modulée 312 et sur l'autre le faisceau secondaire 307 d'onde de pompe, l'une des voies du coupleur 314 étant reliée en sortie à l'amplificateur 302.

Un filtre 313 est disposé sur le trajet du faisceau émergeant de l'amplificateur optique 302 pour arrêter l'onde de pompe et récupérer seulement à la sortie du dispositif 300 l'onde de sonde modulée, référencée 304. Un atténuateur 321 est placé sur le trajet de l'onde de sonde modulée 312 quittant l'amplificateur optique 301 de manière à ce que l'amplitude de crête de l'onde de sonde incidente sur l'amplificateur optique 302 soit la même que celle de l'onde de sonde 308 incidente sur l'amplificateur optique 301. Une ligne à retard 318 est placée sur le trajet du faisceau secondaire 307 d'onde de pompe de manière à synchroniser l'information portée par le faisceau secondaire 307 d'onde de pompe avec celle portée par l'onde de sonde modulée 312, compte tenu du retard apporté par la traversée de l'amplificateur optique 301 et des autres composants optiques.

Le dispositif 300 est avantageusement intégré au sein d'une structure monolithique, le filtre 313 pouvant cependant être monté sous forme de composant discret en sortie de l'amplificateur 302.

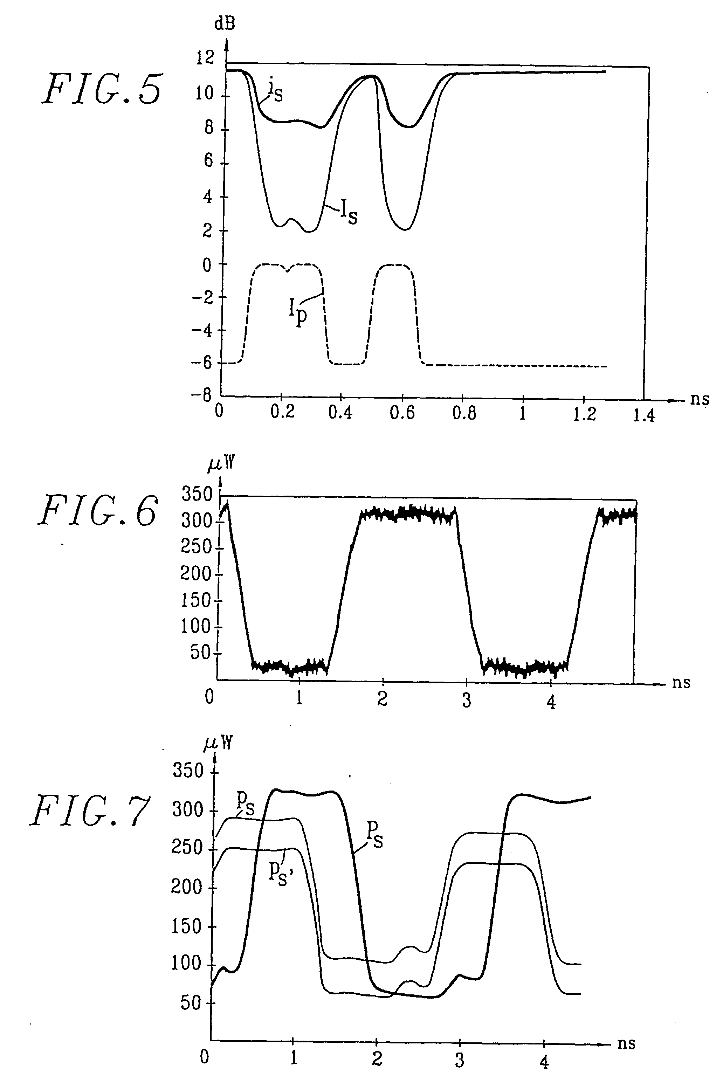

Les figures 4 et 5 correspondent à des résultats obtenus par simulation. La figure 4 montre la réponse simulée d'un dispositif conforme à l'invention (dans une configuration contra-propagative à deux étages, telle que celle décrite en référence à la figure 2), lorsqu'une onde de pompe d'intensité Iₚ est injectée à l'entrée (le taux d'extinction de l'onde de pompe est supérieur à 30 dB). On a indiqué pour comparaison l'intensité iₛ de l'onde de sonde en sortie d'un convertisseur connu n'utilisant qu'un seul amplificateur optique, et l'intensité Iₛ de l'onde de sonde en sortie du dispositif conforme à l'invention. On notera que, grâce à l'invention, le taux d'extinction de l'onde de sonde passe de 5,2 dB à 10,6 dB, la puissance totale de l'onde de pompe étant toutefois deux fois plus élevée que dans le cas d'un convertisseur connu n'utilisant qu'un seul amplificateur optique. Cependant, même dans le cas où une puissance globale d'onde de pompe identique serait utilisée dans une configuration connue à un seul amplificateur optique et dans une configuration conforme à l'invention à plusieurs amplificateurs optiques, le taux d'extinction serait amélioré d'au moins 2 dB.

La figure 5 représente les résultats provenant d'une simulation d'un dispositif convertisseur à trois étages, conforme à l'invention, recevant une onde de pompe d'intensité Iₚ modulée pour porter un signal binaire et dont le taux d'extinction n'est que de 6 dB. On a indiqué, pour comparaison, l'intensité iₛ de l'onde de sonde dans le cas d'un convertisseur connu n'utilisant qu'un seul amplificateur optique, et l'intensité Iₛ de l'onde de sonde quittant le dispositif convertisseur conforme à l'invention. On constatera qu'un dispositif conforme à l'invention peut régénérer de plus de 3 dB le contraste de l'information portée par l'onde de pompe incidente.

Les figures 6 et 7 rassemblent des résultats expérimentaux provenant d'un exemple de réalisation tel que décrit en référence à la figure 2. A titre indicatif, l'onde de pompe est générée ici par un laser de type DFB, avec λₚ = 1553 nm, et modulée en intensité pour porter un signal numérique pseudo-aléatoire ; l'onde de sonde est générée ici par un laser de type DFB, avec λₛ = 1540 nm. La figure 6 représente l'évolution de la puissance de l'onde de pompe pour un débit de 700 Mbits/s. On a représenté, sur la figure 7, l'allure de la puissance Pₛ de l'onde de sonde en sortie du dispositif, le taux d'extinction étant de 7,2 dB. Par comparaison, on a représenté l'allure de la puissance pₛ de l'onde de sonde en sortie d'un convertisseur connu à un seul étage : le taux d'extinction est de 4,14 dB. La courbe pₛ' représente l'allure de la puissance de l'onde de sonde en sortie d'un convertisseur connu à un seul étage, mais pour une puissance d'onde de pompe égale à la puissance du faisceau incident d'onde de pompe dans le cas d'un convertisseur conforme à l'invention, à deux étages : on obtient grâce à l'invention un meilleur taux d'extinction (7,2 dB au lieu de 6,06 dB).

En conclusion, l'invention permet d'améliorer nettement le taux d'extinction de l'onde de sonde, sans faire de compromis entre la rapidité de transmission de l'information et le taux d'extinction obtenu. Un dispositif selon l'invention est par ailleurs plus robuste qu'un dispositif à interférométrie tel que proposé dans l'art antérieur, car il ne nécessite pas le contrôle précis d'une différence de marche. Pour cette même raison, et compte tenu du fait que dans un amplificateur optique à semi-conducteur la vitesse de phase d'une onde dépend en général de sa polarisation, la sensibilité à la polarisation de l'onde de sonde n'est pas critique dans l'invention, en comparaison avec les convertisseurs connus utilisant des interféromètres de Mach-Zehnder ou de Michelson. En outre, la bande passante optique n'est limitée dans l'invention que par celle de l'amplificateur optique, et non par celle de l'interféromètre utilisé dans un convertisseur connu exploitant le déphasage de l'onde de sonde.

## Revendications

1. Dispositif (100 ; 200 ; 300) convertisseur de longueur d'onde, destiné à la transmission d'une information portée par un faisceau incident d'onde de pompe (103 ; 203 ; 303) de longueur d'onde λₚ à une onde de sonde (108 ; 208 ; 308) de longueur d'onde λₛ, le dispositif convertisseur (100 ; 200 ; 300) comportant au moins deux amplificateurs optiques à semi-conducteurs (101, 102 ; 201, 202 ; 301, 302), caractérisé en ce que le dispositif comporte des moyens (105 ; 205 ; 305) pour fractionner le faisceau incident d'onde de pompe en faisceaux secondaires d'onde de pompe et injecter sur chacun desdits amplificateurs optiques (101, 102 ; 201, 202 ; 301, 302) un faisceau secondaire respectif (106, 107 ; 206, 207 ; 306, 307) d'onde de pompe, et en ce que lesdits amplificateurs optiques (101, 102 ; 201, 202 ; 301, 302) sont agencés en série sur le trajet de l'onde de sonde de manière à moduler chacun en intensité cette dernière par phénomène de saturation croisée du gain avec le faisceau secondaire d'onde de pompe associé, en vue d'obtenir en sortie du dispositif une onde de sonde (104; 204 ; 304) porteuse de ladite information.

2. Dispositif (200 ; 300) selon la revendication 1, caractérisé en ce qu'au moins un faisceau secondaire (206, 207 ; 306) d'onde de pompe est envoyé sur l'amplificateur optique associé (201, 202 ; 301) avec un sens de propagation inverse de celui de l'onde de sonde.

3. Dispositif selon la revendication 2, caractérisé en ce qu'il comporte un isolateur optique (220) placé sur le trajet du faisceau secondaire d'onde de pompe à la sortie d'un amplificateur optique (202) qui le reçoit avec un sens de propagation contraire à celui de l'onde de sonde, cet isolateur optique (220) étant agencé pour arrêter ledit faisceau secondaire d'onde de pompe tout en permettant la traversée de ladite onde de sonde.

4. Dispositif (200) selon l'une des revendications 2 et 3, caractérisé en ce que tous les amplificateurs optiques (201, 202) reçoivent le faisceau secondaire d'onde de pompe associé avec un sens de propagation contraire à celui de l'onde de sonde.

5. Dispositif selon l'une des revendications 1 à 4, caractérisé en ce qu'il est intégré dans une structure monolithique ou hybride.

6. Dispositif selon l'une des revendications 1 à 5, caractérisé en ce qu'il comporte un atténuateur (121 ; 221 ; 321) placé sur le trajet de l'onde de sonde entre deux amplificateurs optiques (101, 102 ; 201, 202 ; 301, 302) successivement traversés par ladite onde de sonde, de manière à ce que l'intensité de l'onde de sonde incidente sur chacun des amplificateurs optiques ait même amplitude de crête.

7. Dispositif selon l'une des revendications 1 à 6, caractérisé en ce qu'il comporte au moins une ligne à retard (118 ; 218 ; 318) disposée sur le trajet d'un faisceau secondaire d'onde de pompe, cette ligne à retard (118 ; 218 ; 318) étant agencée de sorte que l'information portée par chacun desdits faisceaux secondaires d'onde de pompe arrive sur les amplificateurs optiques associés en synchronisme avec l'information portée par l'onde de sonde.

8. Dispositif selon l'une des revendications 1 à 7, caractérisé en ce qu'il comporte au moins un filtre (113) placé sur le trajet de l'onde de sonde à sa sortie d'un amplificateur optique (101), ce filtre étant de sélectivité choisie de manière à arrêter l'onde de pompe et à laisser passer l'onde de sonde.

9. Dispositif selon l'une des revendications 1 à 8, caractérisé en ce qu'il comporte une source optique (109 ; 209 ; 309) adaptée à émettre une onde de sonde d'intensité constante, à laquelle ladite information doit être transmise.

10. Dispositif selon l'une des revendications 1 à 9, caractérisé en ce que ladite information est un signal binaire de débit supérieur ou égal à 10 Gbits/s.

## Patentansprüche

1. Wellenlängen-Konvertervorrichtung (100; 200; 300), welche für die Übertragung einer Information, die von einem einfallenden Pumpwellenstrahl (103; 203; 303) der Wellenlänge λₚ getragen ist, an eine Sondenwelle (108; 208; 308) der Wellenlänge λₛ ausgelegt ist, wobei die Konvertervorrichtung (100; 200; 300) wenigstens zwei optische Halbleiter-Verstärker (101,102; 201,202; 301,302) aufweist, dadurch gekennzeichnet, daß die Vorrichtung Mittel (105; 205; 305) zum Aufteilen des einfallenden Pumpwellenstrahles in sekundäre Pumpwellenstrahlen und zum Einführen jeweils eines sekundären Pumpwellenstrahls (106,107; 206,207; 306,307) in jeden der optischen Verstärker (101,102; 201,202; 301,302) aufweist, und daß die optischen Verstärker (101, 102; 201,202; 301,302) in Serie derart auf dem Weg der Sondenwelle angeordnet sind, um jeweils letztere - über das Phänomen der mit dem Verstärkungsfaktor gekreuzten Sättigung - in der Intensität mit dem beteiligten sekundären Pumpwellenstrahl zu modulieren, um am Ausgang der Vorrichtung eine die Information tragende Sondenwelle (104; 204; 304) zu erhalten.

2. Vorrichtung (200; 300) nach Anspruch 1, dadurch gekennzeichnet, daß wenigstens ein sekundärer Pumpwellenstrahl (206,207; 306) an den beteiligten optischen Verstärker (201,202; 301) mit einer Ausbreitungsrichtung geschickt wird, die entgegengesetzt zu derjenigen der Sondenwelle ist.

3. Vorrichtung nach Anspruch 2, dadurch gekennzeichnet, daß sie einen optischen Isolator (220) aufweist, der auf dem Weg des sekundären Pumpwellenstrahles an dem Ausgang eines optischen Verstärkers (202) angeordnet ist, der diesen mit einer Ausbreitungsrichtung empfängt, die entgegengesetzt zu derjenigen der Sondenwelle ist, wobei dieser optische Isolator (220) zum Aufhalten des sekundären Pumpwellenstrahles angeordnet ist, während er den Durchgang der Sondenwelle zuläßt.

4. Vorrichtung (200) nach einem der Ansprüche 2 und 3, dadurch gekennzeichnet, daß alle optischen Verstärker (201, 202) den beteiligten sekundären Pumpwellenstrahl mit einer Ausbreitungsrichtung empfangen, die entgegengesetzt zu derjenigen der Sondenwelle ist.

5. Vorrichtung nach einem der Ansprüche 1 bis 4, dadurch gekennzeichnet, daß sie in eine monolithische oder hybride Struktur integriert ist.

6. Vorrichtung nach einem der Ansprüche 1 bis 5, dadurch gekennzeichnet, daß sie ein Dämpfungsglied (121; 221; 321) aufweist, das auf dem Weg der Sondenwelle zwischen zwei optischen Verstärkern (101,102; 201,202; 301,302) angeordnet ist, die nacheinander von der Sondenwelle durchquert werden, damit die Intensität der einfallenden Sondenwelle bei jedem der optischen Verstärker die gleiche Spitzenamplitude hat.

7. Vorrichtung nach einem der Ansprüche 1 bis 6, dadurch gekennzeichnet, daß sie wenigstens eine Verzögerungslinie (118; 218; 318) aufweist, die auf dem Weg eines sekundären Pumpwellenstrahles angeordnet ist, wobei diese Verzögerungslinie (118; 218; 318) derart angeordnet ist, daß die von jedem der sekundären Pumpwellenstrahlen getragene Information bei den beteiligten optischen Verstärkern synchron mit der von der Sondenwelle getragenen Information ankommt.

8. Vorrichtung nach einem der Ansprüche 1 bis 7, dadurch gekennzeichnet, daß sie wenigstens einen Filter (113) aufweist, der auf dem eg der Sondenwelle bei ihrem Ausgang von einem optischen Verstärker (101) angeordnet ist, wobei dieser Filter eine Selektivität bzw. Trennschärfe aufweist, die derart ausgewählt wird, daß sie die Pumpwelle aufhält und die Sondenwelle passieren läßt.

9. Vorrichtung nach einem der Ansprüche 1 bis 8, dadurch gekennzeichnet, daß sie eine Lichtquelle (109; 209; 309) aufweist, die zum Aussenden einer Sondenwelle konstanter Intensität ausgelegt ist, auf welcher die Information übertragen werden soll.

10. Vorrichtung nach einem der Ansprüche 1 bis 9, dadurch gekennzeichnet, daß die Information ein Binärsignal mit einer Übertragungsrate größer oder gleich 10 Gbits/s ist.

## Claims

1. Wavelength conversion apparatus (100; 200; 300) for conveying data carried by an incident pump wave beam (103; 203; 303) of wavelength λₚ to a probe wave (108; 208; 308) of Wavelength λₛ, the converter apparatus (100, 200; 300) comprising at least two semiconductor optical amplifiers (101, 102; 201, 202; 301, 302) characterized in that the apparatus includes means (105; 205; 305) for splitting the incident pump wave beam into secondary pump wave beams and for injecting a respective secondary pump wave beam (106, 107; 206, 207; 306, 307) into each of said optical amplifiers (101, 102; 201, 202; 301, 302), and in that said optical amplifiers (101, 102; 201, 202; 301, 302) are disposed in series on the path of the probe wave so that each of them modulates the intensity thereof by the crossover gain-saturation phenomena with the associated secondary pump wave beam, for the purpose of obtaining at the output from the apparatus a probe wave (104; 204; 304) that carries said information.

2. Apparatus (200; 300) according to claim 1, characterized in that at least one of the secondary beams (206, 207; 306) of the pump wave is applied to the associated optical amplifier (201, 202; 301) in a direction of propagation that is opposite to that of the probe wave.

3. Apparatus according to claim 2, characterized in that it includes an optical isolator (220) placed on the path of the secondary pump wave beam at the outlet from the optical amplifier (202) that receives it in a propagation direction opposite to that of the probe beam, said optical isolator (220) being organized to stop said secondary pump wave beam while passing said probe beam.

4. Apparatus (200) according to claim 2 or 3, characterized in that all of the optical amplifiers (201, 202) receive the associated pump wave secondary beam in a propagation direction that is opposite to that of the probe wave.

5. Apparatus according to any one of claims 1 to 4, characterized in that it is integrated in a structure that is monolithic or hybrid.

6. Apparatus according to any one of claims 1 to 5, characterized in that it includes an attenuator (121; 221; 321) placed on the path of the probe beam between the two optical amplifiers (101, 102; 201, 202; 301, 302) through which the probe beam passes in succession, in such a manner that the intensity of the probe beam applied to each of the optical amplifiers has the same peak amplitude.

7. Apparatus according to any one of claims 1 to 6, characterized in that it includes at least one delay line (118; 218; 318) disposed on the path of the secondary pump wave beam, said delay line (118; 218; 318) being organized so that the data carried by each of said secondary pump wave beams reaches the associated optical amplifiers synchronously with the data carried by the probe wave.

8. Apparatus according to any one of claims 1 to 7, characterized in that it includes at least one filter (113) placed on the path of the probe wave at its outlet from an optical amplifier (101), said filter being of selectivity chosen in such a manner as to stop the pump wave while allowing the probe wave to pass therethrough.

9. Apparatus according to any one of claims 1 to 8, characterized in that it includes a light source (109; 209; 309) adapted to emit a probe wave of constant intensity, to which probe wave said data is to be conveyed.

10. Apparatus according to any one of claims 1 to 9, characterized in that said data is a binary signal at a rate equal to or greater than 10 Gbit/s.
